# EUROPEAN PATENT APPLICATION

(11) **EP 1 434 426 A2**
(43) Date of publication of application: **30.06.2004**
(21) Application number: 03029192.6
(22) Date of filing: 18.12.2003
(51) Int. Cl.: H04N 5/225

(54) **Camera module and manufacturing method thereof**

(30) Priority: 18.12.2002 JP 2002366274
(71) Applicant: Sanyo Electric Co., Ltd., Moriguchi-shi, Osaka 570-8677 (JP)
(72) Inventor: Ikeda, Osamu, Ora-gun Gunma (JP)
(74) Representative: Glawe, Delfs, Moll & Partner

(57) **Abstract**

A camera module for a mobile device is reduced in size and production cost. A lens (10) being essentially same in size as an image sensor chip (20) is bonded to a surface of the image sensor chip (20). An IR filter (30) is bonded to the lens and an iris material is provided onto the IR filter (31). Bump electrodes (25A, B) formed on a back surface of the image sensor chip (20) are connected to a printed circuit board.

## Description

### BACKGROUND OF THE INVENTION

### Field of the Invention

This invention relates to a camera module and its manufacturing method, specifically to a small size camera module suitable to be incorporated into a portable device such as a mobile phone and a manufacturing method of such a device.

### Description of the Related Art

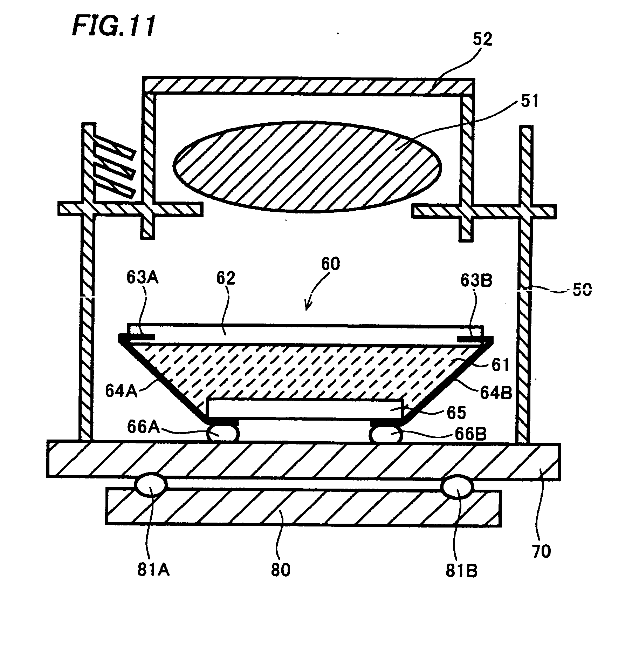

A mobile phone with camera function has come into widespread use in recent years. This type of mobile phone incorporates a small size camera module. Fig. 11 is a cross-sectional view showing a structure of such a camera module.

Fig. 11 shows a lens-barrel 50, a lens 51 mounted inside the lens-barrel 50 and an IR filter 52 to block infrared radiation attached to a mouth of the lens-barrel 50. It also shows an image sensor chip 60 housed in a space within the lens-barrel 50 and electrically connected to a printed circuit board 70.

The image sensor chip 60 converts light incident from a photogenic subject through the IR filter 52 and the lens 51 into electric signals. CCDs (Charge Coupled Devices) are formed in a surface of a silicon chip 61 and a supporting glass substrate 62 is bonded to the silicon chip 61 to bolster it in the image sensor chip 60.

Each of redistribution wirings 64A and 64B is formed extending from each of electrode pads 63A and 63B, which are formed on a peripheral surface of the image sensor chip 60, over a side surface and to a back surface of the silicon chip 61.

Each of the redistribution wirings 64A and 64B extends onto a glass substrate 65 which is bonded to the back surface of the silicon chip 61. Each of bump electrodes 66A and 66B is formed on an end of each of the redistribution wirings 64A and 64B extending to the glass substrate 65. The bump electrodes 66A and 66B are connected to the printed circuit board 70.

A DSP (Digital Signal Processor) 80, which performs video signal processing on the electric signals from the image sensor chip 60, is connected to a back surface of the printed circuit board 70 through bump electrodes 81A and 81B.

In the camera module described above, the lens-barrel 50, the lens 51, the IR filter 52 and the image sensor chip 60 are discrete components, and the camera module is assembled by putting these discrete components together. This causes difficulty in reducing the size and production cost of the camera module.

The object o this invention is to provide a camera module and a manufacturing method thereof that lessens this drawback.

### SUMMARY OF THE INVENTION

The solution according to the invention lies in the features of the independent claims and preferably in those of the dependent claims.

The invention provides a camera module that comprises an image sensor chip comprising a semiconductor chip having a photoelectronic transducer formed on a first portion of a front surface of the semiconductor chip and having an electrode pad formed on a second portion of the front surface and connected to a terminal for external connection disposed on a back surface of the semiconductor chip. The module also comprises a lens bonded to the image sensor chip.

The invention also provides a method of manufacturing a camera module. The method includes providing an image sensor wafer comprising a plurality of image sensor chips. Each of the image sensor chips comprises a photoelectronic transducer and a terminal for external connection. The method also includes providing a lens array comprising a plurality of lenses. Each of the lenses is configured to cover a corresponding image sensor chip. The method further includes bonding the lens array to a surface of the image sensor wafer to form a bonded assembly, and dividing the bonded assembly into individual camera modules so that each of the camera modules includes one of the image sensor chips and one of the lenses. Furthermore, a filter and an aperture may be incorporated in to the module. An additional lens may be disposed over the lens bonded to the image sensor wafer.

The camera module according to the invention, the lens, the image sensor, the optional filter as well as the optional iris material are integrated into a single unit. By virtue of this it is possible to reduce the size and the production cost of this camera module. Further, with the manufacturing method according to the invention, the image sensor wafer, the lens array and optional components like the iris or the filter are bonded together to form an integrated structure which is divided afterwards into individual camera modules. This is a much less complex task and therefore allows for a reduced production cost in contrast to the manufacturing method according to the prior art, wherein the individual components are assembled separately for each camera module. Further, the integration achieved by the manufacturing method according to the invention provides for a reduced size of the camera module.

### BRIEF DESCRIPTION OF THE DRAWINGS

Fig. 1 is a plan view showing a camera module according to a first embodiment of this invention.
Fig. 2 is a cross-sectional view showing section X-X in Fig. 1.
Fig. 3 is a cross-sectional view showing the camera module according to a modification to the first embodiment of this invention.
Fig. 4 is a cross-sectional view showing a camera module according to a second embodiment of this invention.
Fig. 5 is a cross-sectional view showing the camera module according to a modification to the second embodiment of this invention.
Fig. 6 shows a manufacturing method of the camera module according the first embodiment of this invention.
Fig. 7A and Fig. 7B are plan views showing a lens array used in the method of Fig. 6.
Fig. 8A and Fig. 8B are plan views showing a different lens array used in the method of Fig. 6.
Fig. 9A and Fig. 9B are plan views showing a further different lens array used in the method of Fig. 6.
Fig. 10 is a cross-sectional view showing the manufacturing method of the camera module according the embodiments of this invention.
Fig. 11 is a cross-sectional view showing a conventional camera module.

### DETAILED DESCRIPTION OF THE INVENTION

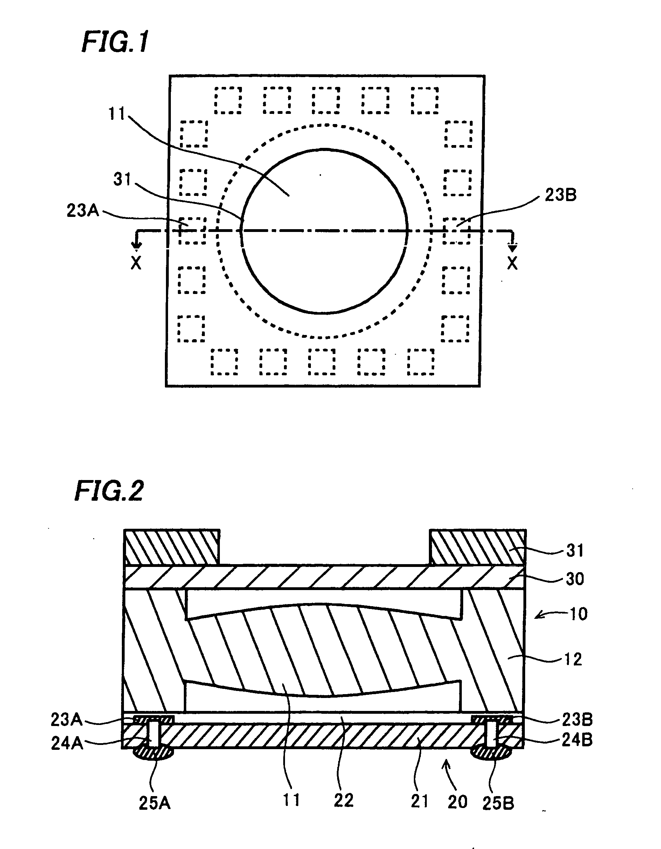

A structure of a camera module according to a first embodiment of this invention will be described. Fig. 1 is a plan view showing the camera module and Fig. 2 is a cross-sectional view showing a section X-X in Fig. 1.

The camera module includes a basic integrated unit of a lens 10 and an image sensor chip 20 bonded to each other, with addition of an IR filter bonded onto the lens 10 and an iris material 31 disposed on the IR filter 30.

The lens 10 includes a lens body 11 which is circular-shaped on the plan view and a lens frame 12 surrounding the lens body 11 and molded together with the lens body 11 to make a single piece of the lens 10.

The lens frame 12 is built outside a periphery of the lens body 11, and its bottom surface is bonded to a peripheral surface of the image sensor chip 20 using an adhesive or the like. A top surface of the lens frame 12 is bonded to the IR filter 30 using an adhesive or the like. The lens 10 can be made by injection mold, for example. In this case, it is made of plastic.

The iris material 31 is made of a film such as an acrylic film or a polyolefin film, and is bonded to the IR filter 30. The iris material 31 may be formed by printing a light shielding material on a surface of the IR filter or the lens body 11, instead of the film described above.

In the image sensor chip 20, CCDs, which are photoelectronic transducers, are formed in a surface of a silicon chip 21, to which a supporting glass substrate 22 to bolster the silicon chip 21 is bonded using an adhesive or the like. Electrode pads 23A and 23B are formed on a peripheral surface of the silicon chip 21. Each of the electrode pads 23A and 23B is connected with an input/output circuit of the image sensor chip 20.

Bottom surface of each of the electrode pads 23A and 23B is connected with each of redistribution wirings 24A and 24B which penetrate through the silicon chip 21 to reach a back surface of the image sensor chip 20, where each of bump electrodes 25A and 25B is formed on exposed surface of each of the redistribution wirings 24A and 24B, respectively.

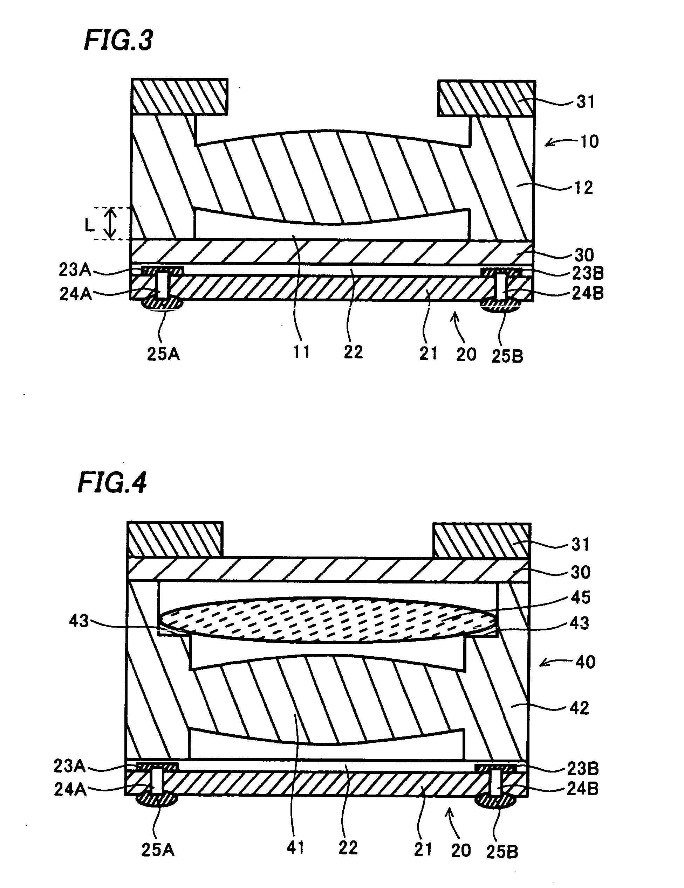

The IR filter 30 is bonded onto the lens 10 in the structure shown in Fig. 2. Instead, the IR filter 30 may be bonded between the image sensor chip 20 and the lens 10, as shown in Fig. 3. By doing so, a foot length L of the lens frame 12 is shortened by a thickness of the IR filter 30, making the injection molding of the lens frame 12 easier.

With the camera module of the structure described above, it is possible to reduce the size and the production cost of the camera module compared with the prior art, since the lens 10, the image sensor chip 20, the IR filter 30 and the iris material 31 are integrated into a single unit.

When filtering function is given to the supporting glass substrate 22 which bolsters the silicon chip 21 in the structure described above, the IR filter 30 can be omitted, leading to cost reduction due to reduction in number of parts. In this case, the filtering function is obtained by vacuum deposition of metal on the supporting glass substrate 22 or incorporating copper particles into the supporting glass substrate 22. What is mentioned above is also applicable to the second embodiment, which will be described hereafter.

Next, a structure of a camera module according to a second embodiment of this invention will be described hereafter.
Fig. 4 is a cross-sectional view showing the camera module according to the second embodiment of this invention. The same symbols are assigned to the same components in Fig. 4 as in Fig.2, and explanations of them are omitted.

While a single lens 10 is used in the first embodiment, two lenses are used in the second embodiment to support high-definition images of 300,000 pixels or above.

A lens frame 42 of a lens 40 is carved to form a lens mount 43 where a glass lens 45 is mounted on and fixed to with an adhesive, as shown in Fig. 4. The glass lens 45 is placed over the lens 41 with a predetermined spacing, using the lens mount 43 as a positioning unit for the glass lens 45. Incident light from a photogenic subject goes through the two lenses to reach an image sensor chip 20.

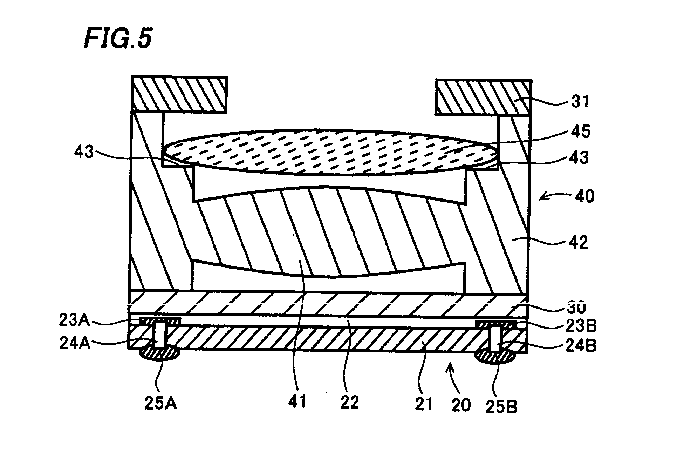

An IR filter 30 may be bonded between the image sensor chip 20 and the lens 40, as shown in Fig. 5. By doing so, a foot length L of the lens frame 42 is shortened by a thickness of the IR filter 30, making the injection molding of the lens frame 42 easier.

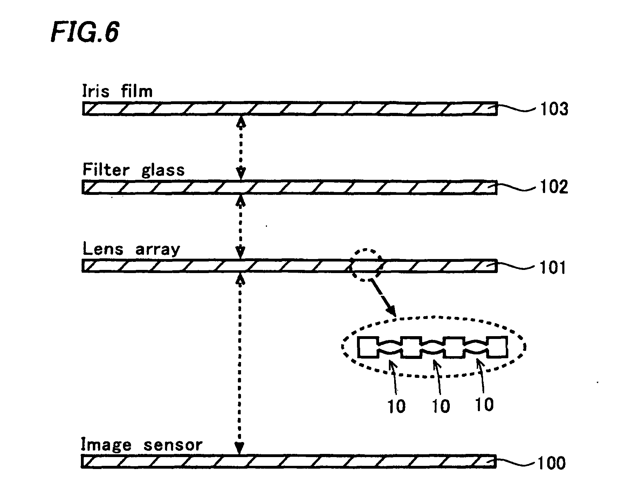

Next, a manufacturing method of the camera module described above will be explained hereafter, referring to Fig. 6. An image sensor wafer 100, in which a plurality of image sensor chips 20 formed by wafer processing is disposed in a matrix form, is provided as shown in Fig. 6. Also, a lens array 101, which is a plurality of lenses 10 each having equivalent shape and size to the image sensor chip 20, is provided.

And an IR filter glass 102 in the same shape as the wafer is provided. Similarly, an iris film 103 having the same shape as the wafer is also provided. Then the image sensor wafer 100, the lens array 101, the IR filter glass 102 and the iris film 103 are bonded together, forming an integrated structure.

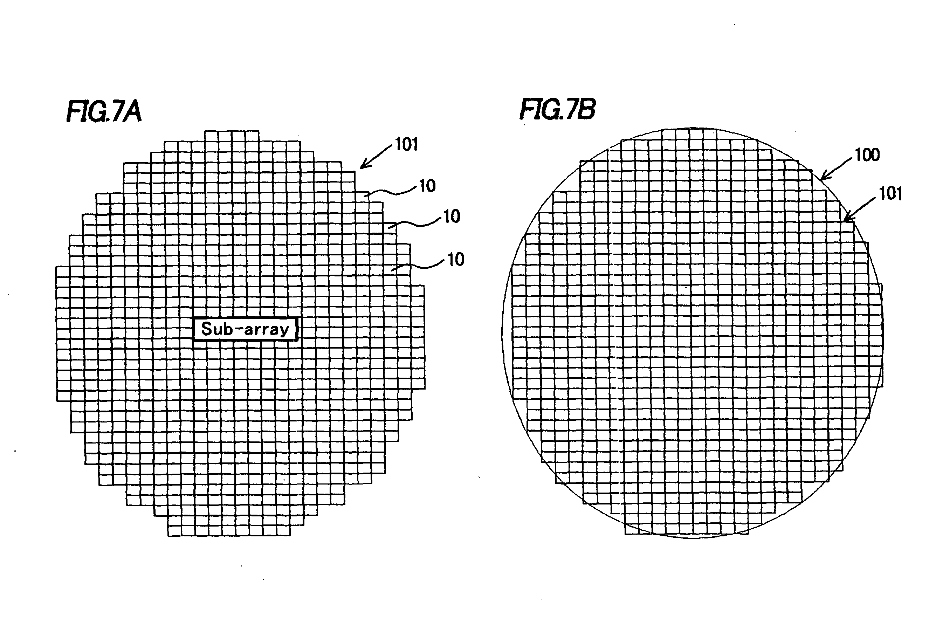

Fig. 7A is a plan view showing a first example of the lens array 101. The first example of the lens array 101 has a multitude of lenses 10 arranged to make an envelope of the array in a shape essentially same as the wafer, as shown in Fig. 7A. And the lens array 101 is bonded to the image sensor wafer 100, as shown in Fig. 7B.

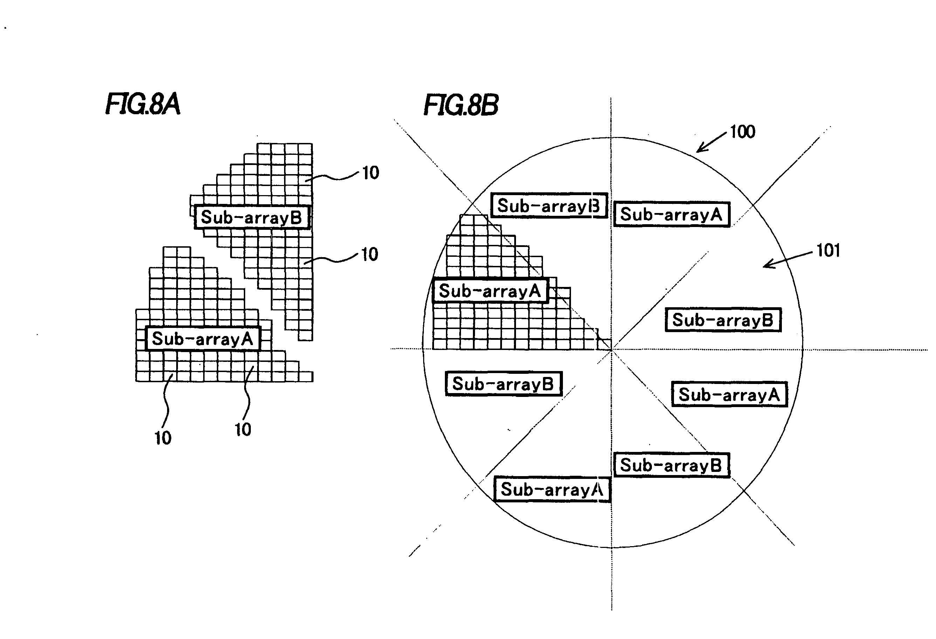

Fig. 8A is a plan view showing a second example of the lens array 101. The second example of the lens array 101 is constructed using two types of sub-arrays, i.e., sub-array A and sub-array B, each nearly rectangular shaped, as shown in Fig. 8A. Four of the sub-array As and four of the sub-arrays B are bonded to the image sensor wafer 100, as shown in Fig. 8B.

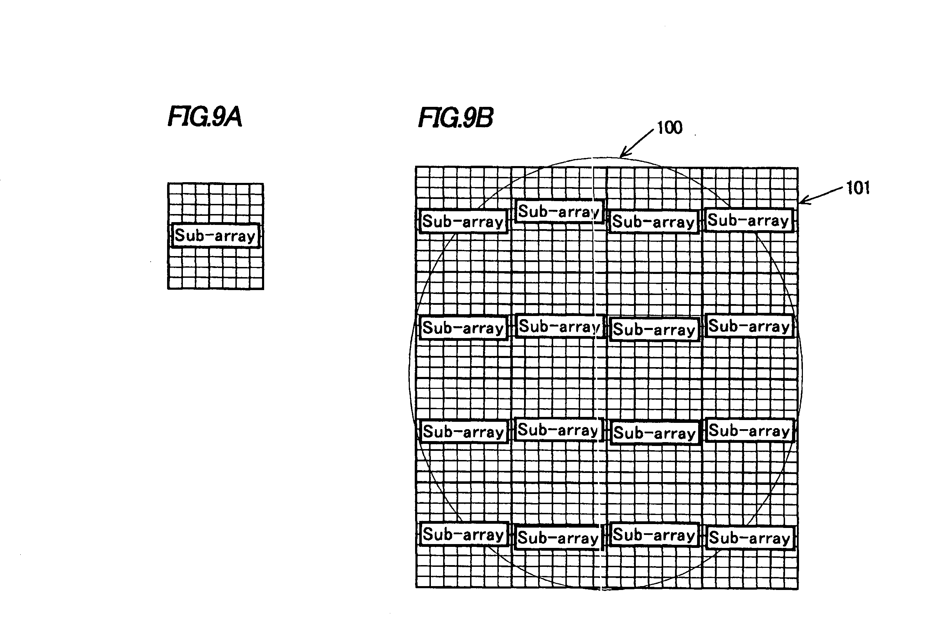

Fig. 9A is a plan view showing a third example of the lens array 101. The third example of the lens array 101 is constructed using only a single type of rectangular sub-array, as shown in Fig. 9A.

Sixteen of the sub-arrays are bonded to the image sensor wafer 100, as shown in Fig. 9B. Although portions which fall off the image sensor wafer 100 are wasted, the third example of the lens array 101 has an advantage of manufacturing simplicity, since it includes only one type of sub-array.

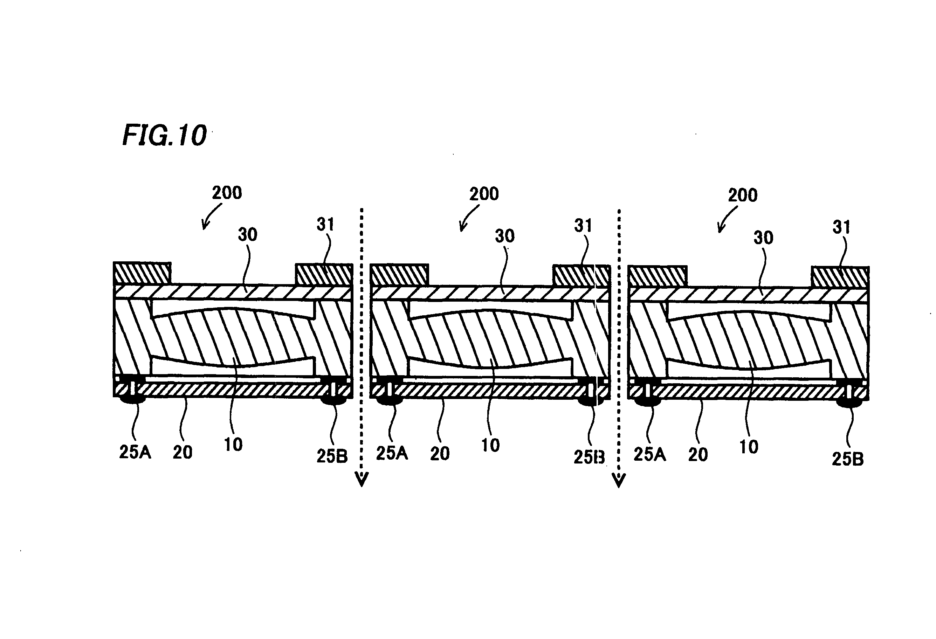

After the bonding process described above, the integrated structure described above is divided into individual camera modules 200 by cutting along borders between the image sensor chips with a dicing blade or a laser, as shown in Fig. 10.

Then, each of the individual camera modules 200 is mounted on a printed circuit board through bump electrodes 25A and 25B provided on a back surface of the image sensor chip 20.

When the lens 10 is made of plastic, heat resistance of the plastic must be examined, because heat treatment is usually performed on the bump electrodes 25A and 25B when the camera module 200 is mounted on the printed circuit board. In this case, it is better to use a plastic material with higher heat resistance or gold bumps which can make connection at lower temperature.

The manufacturing method described above corresponds to the structure shown in Fig. 2. The manufacturing method is adjusted to the structure shown in Fig. 3 by bonding the filter glass 102 between the image sensor wafer 100 and the lens array 101.

In manufacturing the structure of the second embodiment shown in Fig. 4, the filter glass 102 is bonded after the image sensor wafer 100 and the lens array 101 are bonded together and the glass lens 45 is mounted above each of the lenses 10. The rest of the manufacturing process remains the same as described above.

In manufacturing the structure of the second embodiment shown in Fig. 5, the iris film 103 is bonded after the image sensor wafer 100, the filter glass 102 and the lens array 101 are bonded together in this order and the glass lens 45 is mounted above each of the lenses 10. The rest of the manufacturing process remains the same as described above.

Furthermore, the glass lens 45 may be mounted and bonded above the individual lens 10 after the image sensor wafer 100, the filter glass 102 and the lens array 101 are bonded together in this order and divided into individual camera modules 200.

Production cost is substantially reduced since the image sensor wafer 100, the lens array 101 and others are bonded together to form the integrated structure which is afterwards divided into individual camera modules in the manufacturing method of the camera module described above. In contrast, in the conventional manufacturing method, the individual components are assembled separately for each camera module.

Thus, the invention provides a camera module for a portable device whose size is reduced to the size of the image sensor chip and is manufactured at a substantially reduced cost.

## Claims

1. A camera module comprising:
- an image sensor chip (20) comprising a semiconductor chip (21) having a photoelectronic transducer formed on a first portion of a front surface of the semiconductor chip (21) and having an electrode pad (23A, B) formed on a second portion of the front surface and connected to a terminal (25A, B) for external connection disposed on a back surface of the semiconductor chip (21); and
- a lens (10) bonded to the image sensor chip (20).

2. The camera module of claim 1, wherein the image sensor ship (20) and the lens (10) substantially have a same size with respect to a primary plane thereof.

3. The camera module of claim 1 or 2, further comprising a filter (30) to block light incident on the lens (10) at a predetermined range of wavelength.

4. The camera module of claim 3, further comprising an iris portion (31) disposed on the filter (30) so as to provide an aperture for the light.

5. The camera module of claim 1 or 2, further comprising a filter (30) disposed between the image sensor chip (20) and the lens (10).

6. The camera module of claim 5, further comprising an iris portion (31) disposed on the lens (10) so as to provide an aperture for the light.

7. The camera module according to any of claims 1 to 6, further comprising another lens (40) disposed above the lens (10) bonded to the image sensor chip (20).

8. The camera module of claim 7, further comprising a positioning portion (43) positioning said another lens (40) at a predetermined distance from the lens (10) bonded to the image sensor chip (20).

9. A method of manufacturing a camera module comprising:
- providing an image sensor wafer (100) comprising a plurality of image sensor chips (20), each of the image sensor chips comprising a photoelectronic transducer and a terminal for external connection;
- providing a lens array (101) comprising a plurality of lenses (10), each of the lenses (10) being configured to cover a corresponding image sensor chip (20);
- bonding the lens array (101) to a surface of the image sensor wafer (100) to form a bonded assembly; and
- dividing the bonded assembly into individual camera modules (200) so that each of the camera modules (200) comprises one of the image sensor chips (20) and one of the lenses (10).

10. The method of claim 9, wherein a primary surface of the lens array (101) and a primary surface of the image sensor wafer (100) have substantially a same size.

11. The method of claim 9, wherein the lens array (101) comprises a plurality of sub arrays.

12. The method of claim 9, wherein the lens array (101) comprises a plurality of rectangular sub arrays.

13. A method of manufacturing a camera module comprising:
- providing an image sensor wafer (100) comprising a plurality of image sensor chips (20), each of the image sensor chips comprising a photoelectronic transducer and a terminal for external connection;
- providing a lens array (101) comprising a plurality of lenses (10), each of the lenses being configured to cover a corresponding image sensor chip (20);
- providing a filter (102) and an iris portion (103);
- bonding the image sensor wafer (100), the lens array (101), the filter (102) and the iris portion (103) together to form a bonded assembly; and
- dividing the bonded assembly into individual camera modules (200) so that each of the camera modules (200) comprises one of the image sensor chips (20) and one of the lenses (10).

14. A method of manufacturing a camera module comprising:
- providing an image sensor wafer (100) comprising a plurality of image sensor chips (20), each of the image sensor chips (20) comprising a photoelectronic transducer and a terminal for external connection;
- providing a lens array (101) comprising a plurality of lenses (10), each of the lenses (10) being configured to cover a corresponding image sensor chip (20);
- bonding the lens array (101) to a surface of the image sensor wafer (100) to form a bonded assembly;
- mounting an additional lens (40) over each of the lens (10); and
- dividing the bonded assembly into individual camera modules (200) so that each of the camera modules (200) comprises one of the image sensor chips (20) and one of the lenses (10, 40).

15. The method of claim 14, wherein the additional lens (40) is mounted on the lens array (101) after the lens array (101) is bonded to the image sensor wafer (100).

16. The method of claim 14, wherein the additional lens (40) is mounted on each of the individual camera modules (200) that are separated from each other.

17. A camera module comprising:
- an image sensor chip (20) comprising a photoelectronic transducer; and
- a lens (10) bonded to the image sensor chip (20), the lens (10) comprising a lens body (11) and a lens frame (12),
wherein a surface of the lens frame (12) is configure to serve as a barrel of the camera module.
